# EUROPÄISCHE PATENTSCHRIFT

(11) **EP 1 840 940 B1**
(45) Veröffentlichungstag und Bekanntmachung des Hinweises auf die Patenterteilung: **10.09.2014**
(21) Anmeldenummer: 06006328.6
(22) Anmeldetag: 28.03.2006
(51) Int. Cl.: B81C 1/00, G03F 7/16, H01L 21/67

(54) **Vorrichtung und Verfahren zum Beschichten eines mikro- und/oder nanostrukturierten Struktursubstrats**
Apparatus and process for coating micro or nanostructured substrates
Appareil et procédé pour le revêtement des substrats micro- ou nanostructurés

(43) Veröffentlichungstag der Anmeldung: 03.10.2007
(73) Patentinhaber: Thallner, Erich, 4782 St. Florian (AT)
(72) Erfinder: Thallner, Erich, 4782 St. Florian (AT)
(74) Vertreter: Schweiger, Johannes

(56) Entgegenhaltungen:
- EP-A- 0 540 447
- WO-A-86/02744
- FR-A- 2 597 372
- FR-A1- 2 597 372
- US-A- 4 290 384
- US-A- 4 696 885
- US-A- 5 670 210
- US-A- 5 993 546
- US-A1- 2001 001 407
- US-A1- 2002 176 936
- US-B1- 6 174 651
- US-B1- 6 245 150
- US-B1- 6 485 568
- PATENT ABSTRACTS OF JAPAN Bd. 005, Nr. 044 (E-050), 24. März 1981 (1981-03-24) -& JP 55 166923 A (TOSHIBA CORP), 26. Dezember 1980 (1980-12-26)
- PATENT ABSTRACTS OF JAPAN Bd. 018, Nr. 458 (E-1596), 25. August 1994 (1994-08-25) -& JP 06 151295 A (MATSUSHITA ELECTRIC IND CO LTD), 31. Mai 1994 (1994-05-31)

## Beschreibung

Die Erfindung betrifft ein Verfahren zum Beschichten eines mikro- und/oder nanostrukturierten Struktursubstrats.

Bei MEMS (mikro-elektro-mechanische Systeme), MOEMS (mikro-optoelektro-mechanische Systeme) und NEMS (nano-elektro-mechanische Systeme) handelt es sich um eine Kombination aus mechanischen sowie optischen Elementen, Sensoren, Aktoren und elektronischen Schaltungen auf einem Struktursubstrat. Weiterhin können MEMS und NEMS optische, chemische und/oder biologische Komponenten enthalten. Für die Herstellung von MEMS und NEMS ist es meistens notwendig, die Oberfläche des strukturierten Substrates, insbesondere eines Wafers, bevorzugt aus Halbleitermaterialien und/oder verformbaren Kunststoffen, mit einer Beschichtung zu versehen. Meist wird hierfür Fotolack verwendet, um in einem weiteren Verfahrensschritt lithographische Strukturen zu übertragen.

Die Beschichtung derartiger mikro- und/oder nanostrukturierter Struktursubstrate gestaltet sich als schwierig. Im Unterschied zur Halbleiterindustrie, wo Wafer mit einer vergleichsweise ebenen Oberfläche verwendet werden, handelt es sich bei den mikro- und/oder nanostrukturierten Struktursubstraten der MEMS/MOEMS und NEMS um vergleichsweise stark strukturierte Substrate. Diese tiefen Strukturen werden durch Nass- oder Trockenätzen, Prägen oder Formen erzeugt und können verschiedenste Formen sowie unterschiedlichste Tiefen und Flankenausformungen haben. Die Strukturen des Struktursubstrats haben häufig steile Flanken und des Öfteren sogar senkrechte Seitenwände. Derzeit ist es üblich, als Gräben und/oder Löcher ausgebildete Vertiefungen mit einer Tiefe von etwa 300 µm und einer Breite oder einem Durchmesser der oberen Öffnung von etwa 100 µm und einem Neigungswinkel der Seitenwände von bis zu 70° gleichmäßig belackt werden. Die aus der Halbleiterindustrie bekannten Verfahren zur Oberflächenbeschichtung wie Spinbelackung, Aufbringen von Fotolackfolien oder Tauchbelackung eignen sich nicht, da die Beschichtungssubstanz nicht bis auf den Boden der Vertiefungen vordringen kann. Heute ist es üblich, das Struktursubstrat im Sprayverfahren zu beschichten. Hierbei wird mit einer Zerstäuberdüse ein feiner Beschichtungssubstanznebel unter Normaldruckatmosphäre auf die Oberfläche des Struktursubstrats aufgebracht, wobei der Sprühnebel mit Luft/Sauerstoff oder Stickstoff (N²) gelenkt wird. Dabei besteht häufig das Problem, dass die Beschichtungssubstanztröpfchen aufgrund der Oberflächenspannung die schmalen Öffnungen der Vertiefungen verschließen und nicht die gesamten Seitenwände und die Böden der Vertiefungen benetzt. Weiterhin ist es bekannt, den Sprühnebel durch elektrostatische Aufladung, ähnlich dem Pulverbeschichtungsverfahren, bei Normaldruckatmosphäre auf das Struktursubstrat aufzubringen. Die dabei benötigte hohe elektrische Spannung kann jedoch die empfindlichen Strukturen bzw. Schaltungen des Struktursubstrats zerstören. Beschichtungsverfahren sind auch in US 2002/0176936 Al, US 4,290,384, US 6,485,568 B1, EP 0 540 447 A1, US 6,245,150, WO 86/02744, JP 06151295, JP 55166923, FR 2597372, US 5670210, US 4696885, US 2001/0001407, US 6174651 und US 5993546 gezeigt.

Der Erfindung liegt die Aufgabe zugrunde ein Verfahren zum Beschichten eines mikro- und/oder nanostrukturierten Struktursubstrats vorzuschlagen, mit denen eine gleichmäßige Beschichtung der strukturierten Oberfläche des Struktursubstrats mit einer Beschichtungssubstanz möglich ist.

Diese Aufgabe wird verfahrensgemäß mit den Merkmalen des Anspruchs 1 gelöst.

Vorteilhafte Weiterbildungen der Erfindung sind in den Unteransprüchen angegeben.

Der Erfindung liegt der Gedanke zugrunde, das Struktursubstrat auf einer Trägereinrichtung in einer Vakuumkammer anzuordnen. Die Beschichtungssubstanz wird in flüssiger Form vor und/oder während und/oder nach der Evakuierung der Vakuumkammer in diese eingebracht. Durch das Anlegen eines Unterdrucks an die Vakuumkammer wird die Luft auf der Oberflächenstruktur, d.h. aus den Vertiefungen des Struktursubstrats herausgesaugt. Schon während und/oder nach dem Einbringen der Beschichtungssubstanz in die Vakuumkammer wird das Druckniveau in der Vakuumkammer, bevorzugt schlagartig, erhöht. Hierdurch wird die Beschichtungssubstanz in die Vertiefungen des Struktursubstrats hineinbefördert/gezogen, wodurch auch sehr tiefe und schmale Vertiefungen gleichmäßig beschichtet werden. Als Beschichtungssubstanz wird bevorzugt Fotolack eingesetzt. Es ist jedoch auch möglich, das

Struktursubstrat mit anderen Beschichtungssubstanzen, wie Oberflächenaktivierungsmittel, Lösungsmittel, Haftverbesserern oder anderen Chemikalien zu beschichten. Es liegt im Rahmen der Erfindung das Struktursubstrat mehrfach hintereinander, bevorzugt mit unterschiedlichen Beschichtungssubstanzen, zu behandeln bzw. zu beschichten.

Es gibt verschiedene Möglichkeiten, die Beschichtungssubstanz in die Vakuumkammer einzubringen. Gemäß einer besonders einfachen Variante wird die Beschichtungssubstanz im flüssigen Zustand durch eine Einlaufleitung in die Vakuumkammer eingeleitet.

Es hat sich als vorteilhaft erwiesen, das Struktursubstrat vor der Erhöhung des Druckniveaus in der Vakuumkammer, insbesondere mit Hilfe von Heizelementen der Trägereinrichtung zu erwärmen.

Optimale Ergebnisse werden erzielt, wenn das Struktursubstrat vor und/oder während des Einbringens der Beschichtungssubstanz, insbesondere mittels Kühlelementen der Trägereinrichtung, wieder abgekühlt wird. Hierdurch wird die Kondensation von Beschichtungssubstanznebel in den Vertiefungen des Struktursubstrats unterstützt. Mit Hilfe der Heiz- und/oder Kühlelemente können verschiedene Temperaturprofile und -verläufe realisiert werden, wodurch das Beschichtungsergebnis bei unterschiedlichen Struktursubstraten oder Beschichtungssubstanzen beeinflussbar ist.

Zusätzlich oder alternativ ist es denkbar, das Struktursubstrat, bevorzugt mittels der Trägereinrichtung, während oder nach der Einbringung von Beschichtungssubstanz in Rotation zu versetzen, um eine optimale Verteilung der Beschichtungssubstanz auf der Oberfläche des Struktursubstrats zu gewährleisten.

Gemäß einer bevorzugten Ausführungsform ist vorgesehen, dass die Druckerhöhung nach der Evakuierung der Vakuumkammer gleichzeitig mit dem, bzw. durch das Einbringen von Beschichtungssubstanz erfolgt.

Gemäß der bevorzugten Ausführungsform ist zusätzlich zu der Vakuumkammer eine Vernebelungskammer vorgesehen, die über mindestens eine Verbindungsleitung mit der Vakuumkammer verbunden ist. Innerhalb der Vernebelungskammer sind Vernebelungsmittel, insbesondere mindestens eine Düse und/oder andere geeignete Zerstäubungsgeräte, zum Vernebeln der Beschichtungssubstanz vorgesehen. Mithilfe der Vernebelungsmittel wird die Beschichtungssubstanz in der Vernebelungskammer vernebelt. Das Druckniveau in der Vernebelungskammer ist dabei höher als das Druckniveau der evakuierten Vakuumkammer. Noch während oder nach dem Vernebelungsprozess in der Vernebelungskammer wird die mindestens eine Verbindungsleitung zwischen Vernebelungskammer und Vakuumkammer geöffnet, wodurch schlagartig mit Überdruck der Beschichtungssubstanznebel von der Vernebelungskammer in die Vakuumkammer einströmt, wodurch wiederum der Beschichtungssubstanznebel in die Vertiefungen des Struktursubstrates hineinbefördert/hineingezogen wird und gleichmäßig an den Seitenwänden und dem Boden anhaftet.

Optimale Ergebnisse werden erzielt, wenn die Beschichtungssubstanz vor dem Einbringen in die Vakuumkammer innerhalb der Vernebelungskammer erwärmt wird.

Bevorzugt erfolgt das Öffnen der mindestens einen Verbindungsleitung erst nachdem eine gewünschte Beschichtungssubstanzkonzentration in der Vernebelungskammer vorherrscht. Es ist denkbar, die Beschichtungssubstanzkonzentration in der Vernebelungskammer, vorzugsweise durch optische oder chemische Sensoren zu überwachen. Gemäß einer einfachen Ausführungsform kann jedoch auch die Vernebelungskammer über eine vorgegebene Zeitspanne mit Beschichtungssubstanz beschickt werden, bevor die Verbindung zur Vakuumkammer hergestellt wird.

In Weiterbildung ist vorgesehen, dass die Vernebelungskammer volumenveränderlich ausgebildet ist. Bevorzugt weist die Vernebelungskammer eine Bodenplatte auf, die über einen Faltenbalg an die restliche Vernebelungskammer angeschlossen ist. Hierdurch ist es möglich, über die Veränderung des Volumens der Vernebelungskammer Einfluss auf die Konzentration des Beschichtungssubstanznebels innerhalb der Vernebelungskammer sowie Einfluss auf das Druckniveau innerhalb der Vernebelungskammer zu nehmen.

Mit Vorteil weist die Vernebelungskammer auch einen Abfluss auf, um überschüssige Beschichtungssubstanz abführen zu können.

Es ist denkbar, mehrere Beschichtungsvorgänge nacheinander, insbesondere mit unterschiedlichen Beschichtungssubstanzen, vorzunehmen.

Weitere Vorteile und zweckmäßige Ausführungen sind den weiteren Ansprüchen, der Figurenbeschreibung und den Zeichnungen zu entnehmen.

Es zeigen:
- Fig. 1: ein erstes Beispiel einer Vorrichtung zum Beschichten eines mikro- und/oder nanostrukturierten Struktursubstrats, bei der die Beschichtungssubstanz unmittelbar in einer Vakuumkammer vernebelt wird und
- Fig. 2: ein zweites Beispiel einer Vorrichtung mit einer Vernebelungskammer, die über absperrbare Verbindungsleitungen mit der Vakuumkammer verbunden ist.

In den Figuren sind gleiche Bauteile und Bauteile mit gleicher Funktion mit den gleichen Bezugszeichen versehen.

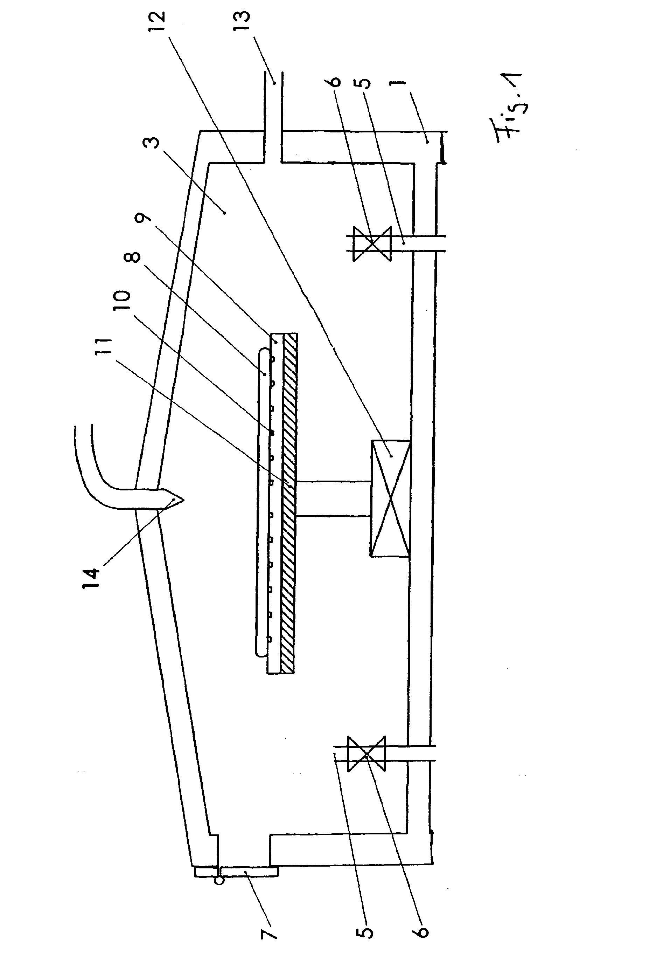

In Fig. 1 ist eine Vorrichtung 1 zum Beschichten eines mikro- und/oder nanostrukturierten Struktursubstrats 8, hier eines Silizium-Wafers, dargestellt. Das Struktursubstrat 8 weist auf seiner in der Zeichnungsebene nach oben weisenden Oberfläche eine Strukturierung mit Vertiefungen auf, wobei die Vertiefungen bei MEMS eine Tiefe von etwa 100 µm bis etwa 400 µm aufweisen. Die Breite bzw. der Durchmesser der oberen Öffnungen dieser Vertiefungen liegt bei MEMS im Bereich von 200 µm bis 100 µm oder weniger. Somit ist bei zumindest einigen der Vertiefungen die Öffnung wesentlich kleiner bemessen als deren Tiefe. Mittels der Vorrichtung 1 ist es möglich, die Oberflächenstruktur des Struktursubstrats 8, insbesondere innerhalb der Vertiefungen, gleichmäßig zu beschichten. Bei NEMS haben die Vertiefungen beispielsweise eine Breite von 20nm und eine Tiefe von 40nm.

Das Struktursubstrat 8 ist in einer Vakuumkammer 3 auf einer Trägereinrichtung 9 (Chuck) fixiert. Zur Fixierung des Struktursubstrats 8 auf der Trägereinrichtung 9 sind Vakuumrillen 10 vorgesehen. Durch Anlegen eines Vakuums an die Vakuumrillen 10 wird das Struktursubstrat 8 mit seiner Unterseite in Richtung Trägereinrichtung 9 gesaugt. Zum Beschicken der Vakuumkammer 9 mit dem Struktursubstrat 8 ist eine verschließbare Klappe 7 vorgesehen.

Die Trägereinrichtung 9 weist ein kombiniertes Heiz-Kühlelement 11 auf, um die Trägereinrichtung 9 und damit das Struktursubstrat 8 zu erwärmen bzw. abzukühlen. Mithilfe des kombinierten Heiz-Kühlelements 11 können die verschiedensten Temperaturprofile bzw. -verläufe realisiert werden.

Die Trägereinrichtung 9 ist mittels eines Motors 12 in der Fixierebene des Struktursubstrats 8 rotierbar, wodurch eine gleichmäßige Verteilung von Beschichtungssubstanz erreicht werden kann, wenn diese nicht in zerstäubter Weise aufgebracht wurde.

Zur Beschickung der Vakuumkammer 3 mit Beschichtungssubstanz ist eine Vernebelungsdüse 14 vorgesehen, wobei als Düse jede Art von Zerstäuberdüse vorgesehen sein kann. Diese ist unmittelbar oberhalb der zu beschichtenden Oberfläche des Struktursubstrates 8 angeordnet.

Zum Beaufschlagen der Vakuumkammer 3 mit Unterdruck, also zum Evakuieren der Vakuumkammer 3, ist die Vakuumkammer 3 über eine Vakuumleitung 13 mit einer nicht dargestellten Vakuumanlage verbunden.

Weiterhin sind im Boden der Vakuumkammer 3 zwei beabstandete Verbindungsleitungen 5 mit jeweils einem Absperrventil 6 vorgesehen. Bei offenen Absperrventilen 6 verbinden die Verbindungsleitungen 5 die Vakuumkammer 3 mit einem höheren Druckniveau als das Druckniveau der evakuierten Vakuumkammer 3, bevorzugt mit der Atmosphäre oder einem Überdruck-Druckmittelspeicher.

Das Beschichten des Struktursubstrats 8 erfolgt auf folgende Weise:

Über die geöffnete Klappe 7 wird mittels eines Roboters ein Struktursubstrat 8 auf das Trägerelement 9 abgelegt. Nach Fixierung des Struktursubstrats 8 und Anlegen von Vakuum an die Vakuumrillen 10 wird die Vakuumkammer 3 mittels der Klappe 7 verschlossen. Auch die Absperrventile 6 sind zu diesem Zeitpunkt geschlossen. Es erfolgt nun eine Besprühung des Struktursubstrats 8 durch die Vernebelungsdüse 14 mit Beschichtungssubstanz, vorzugsweise einer Oberflächenaktivierungschemie, einem Lösungsmittel oder Fotolack. Die verwendete Beschichtungssubstanz ist je nach Oberflächenbeschaffenheit des Struktursubstrats 8, der Struktur der Gräben oder Löcher prozessspezifisch. In weiterer Vorgangsweise kann nun die Trägereinrichtung 9 mittels des Heiz-Kühlelements 11 erwärmt werden. Bereits während der Erwärmung der Trägereinrichtung 9 und damit des Struktursubstrats 8 wird die Vakuumkammer 3 über die Vakuumleitung 13 evakuiert. Nach einer vorgegebenen Zeit wird die Trägereinrichtung 9 mittels des Heiz-Kühlelements 11 abgekühlt. Daraufhin werden die Absperrventile 6 geöffnet, wodurch Überdruck in die Vakuumkammer 3 schlagartig einströmt und die vernebelte Beschichtungssubstanz in die Vertiefungen des Struktursubstrats 8 hineindrückt und so für eine gleichmäßige Beschichtung sorgt.

Es ist auch ausführbar/machbar, die Vakuumkammer 3 erst nach oder bereits während der Evakuierung mit Beschichtungssubstanz über Düse 14 zu beschicken. Das Beschicken nach der Evakuierung hat den Vorteil, dass die Beschichtungssubstanz während der Beschickung nicht durch die Vakuumleitung 13 abgesaugt wird. Die Absperrventile 6 können bereits während oder nach der Beschickung mit Beschichtungssubstanz geöffnet werden. Vor Öffnung der Absperrventile 6 können prozessspezifische Temperaturprofile durchlaufen werden, wodurch eine Änderung der Konsistenz und/oder rheologischen Eigenschaften der Beschichtungssubstanz erreicht wird.

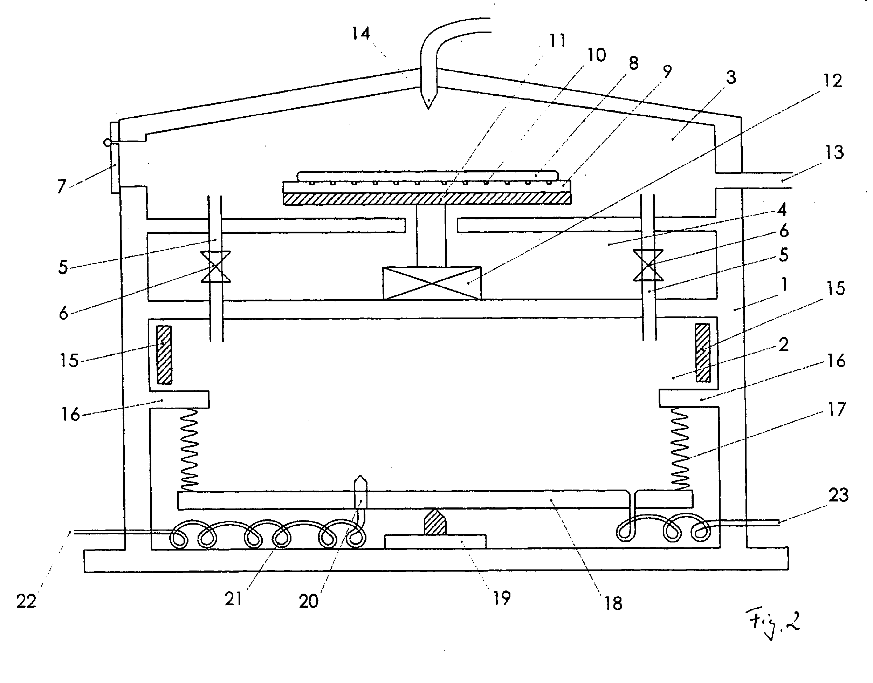

Bei dem Beispiel gemäß Fig. 2 ist zusätzlich zu der Vakuumkammer 3 eine Vernebelungskammer 2 vorgesehen. Der Aufbau der Vakuumkammer 3 mit Trägereinrichtung 9 entspricht im Wesentlichen dem in Fig. 1 gezeigten Aufbau. Auf die in Fig. 2 gezeigte Vernebelungsdüse 14 kann bei dieser Ausführungsform auch verzichtet werden, so dass die Beschickung mit Beschichtungssubstanz ausschließlich über die Vernebelungskammer 2 erfolgt.

Zwischen dem Boden der Vakuumkammer 3 und dem Struktursubstrat 8 ist eine Zwischenwand eingezogen, so dass eine Zwischenkammer 4 gebildet ist, in der der Motor 12 der Trägereinrichtung 9 angeordnet ist. Das Druckniveau der Zwischenkammer 4 entspricht dem Druckniveau der Vakuumkammer 3. Die Zwischenkammer 4 kann auch unter Atmosphärendruck betrieben werden. Dann ist die Welle des Motors 12 im Übergangsbereich zwischen Vakuumkammer 3 und Zwischenkammer 4 abgedichtet.

Im Gegensatz zu dem Ausführungsbeispiel gemäß Fig. 1 verbinden die Verbindungsleitungen 5 mit ihren Absperrventilen 6 die Vakuumkammer 3 nicht mit der Umgebung, sondern mit der Vernebelungskammer 2.

Im oberen Bereich der Vernebelungskammer 2 befinden sich Heizelemente 15 um die Vernebelungskammer 2 beheizen zu können. Unterhalb der Heizelemente 15 befindet sich eine umlaufende Stufe 16, die sich radial nach innen in die Vernebelungskammer 2 erstreckt. Eine Bodenplatte 18 der Vernebelungskammer 2 ist über einen umfänglich geschlossenen Faltenbalg 17 an die Stufe 16 angebunden. Das Volumen der Vernebelungskammer 2 kann über eine Stelleinheit 19 verkleinert oder vergrößert werden, wobei während des Verstellvorgangs sich der Faltenbalg 17 zusammen- oder auseinanderfaltet. In der Bodenplatte 18 ist eine Sprühdüse 20 zur Beschickung der Vernebelungskammer 2 mit Beschichtungssubstanz angeordnet. Über eine flexible Verbindungsleitung 21 und einen Anschluss 22 kann Beschichtungssubstanz, vorzugsweise Fotolack, Lösungsmittel oder andere Chemikalien, in die Vernebelungskammer zugeführt werden. Die Sprühdüse 20 dient zum Zerstäuben der Beschichtungssubstanz, wodurch das Volumen der Vernebelungskammer 2 mit Beschichtungssubstanznebel befüllbar ist.

Ferner ist eine Öffnung innerhalb der Bodenplatte 18 vorgesehen, die mit einer flexiblen Ablassleitung 23 verbunden ist. Über diese können überschüssige Flüssigkeiten, insbesondere Beschichtungssubstanz, die sich in der Nebelkammer 2 absetzt, entfernt werden.

Das Beschichten von Struktursubstraten 8 in der in Fig. 2 gezeigten Vorrichtung 1 erfolgt auf folgende Weise:

Über die Klappe 7 wird ein Struktursubstrat 8 aus Halbleitersubstrat oder geformtem Kunststoff oder Glassubstrat, hier ein Wafer aus Silizium, auf die Trägereinrichtung 9 abgelegt und mittels der Vakuumrillen 10 fixiert. Fakultativ kann nun eine Besprühung des Struktursubstrats 8 mit einer chemischen Substanz, vorzugsweise einer Beschichtungssubstanz, durch die Düse 14 erfolgen. Bevorzugt wird das Struktursubstrat 8 mit einer Oberflächenaktivierungssubstanz, einem Lösungsmittels oder Fotolack besprüht. Nach dem fakultativen Besprühvorgang wird die Vakuumkammer 3 evakuiert. Das Struktursubstrat 8 wird mittels des Heiz-Kühlelements 11 zunächst erwärmt und dann wieder, bevorzugt vor der Beschickung der Vakuumkammer 3 mit Beschichtungssubstanz, abgekühlt. Währenddessen oder danach wird die Vernebelungskammer 2, welche bevorzugt über die Heizelemente 15 erwärmt ist, durch die Sprühdüse 20 mit einem Beschichtungssubstanznebel befüllt. Das Druckniveau innerhalb der Vernebelungskammer 2 entspricht bevorzugt Atmosphärendruck, ist in jedem Fall jedoch höher als das Druckniveau der evakuierten Vakuumkammer 3. Nach ausreichender Befüllung der Vernebelungskammer 2 mit Beschichtungssubstanz, deren Konzentration über nicht dargestellte optische oder chemische Sensoren überwacht wird, werden die Ventile 6 der Verbindungsleitungen 5 geöffnet, wodurch sich die Vakuumkammer 3 schlagartig unter gleichzeitiger Druckzufuhr mit Beschichtungssubstanznebel füllt. Durch die schlagartige Druckerhöhung, insbesondere von Vakuum zu Atmosphärendruck sowie ggf. durch verschiedene Temperaturprofile bzw. -verläufe der Trägereinrichtung 9, wird eine gleichförmige Auskleidung von etwa 300 µm tiefen und etwa 100 µm breiten Hohlräumen, Gräben oder anderen topographischen Figuren, die im Verhältnis zu ihrer Tiefe eine kleine Öffnung nach oben haben, mit einer homogenen Schutzschicht, vorzugsweise einer Fotolackschicht, erhalten.

Je nach Oberflächenbeschaffenheit des Struktursubstrats kann über die Variation der Verweilzeit in der evakuierten Vakuumkammer 3 sowie über das Flutungsprofil (Flüssigkeit oder Vernebeln) sowie über unterschiedliche Temperaturprofile der Trägereinrichtung 9 sowie etwaige Wiederholung des Evakuierungs- und Beschickungszyklus eine genau definierte Beschichtungssubstanzabscheidung an allen vertikalen, tiefen geometrischen Formen des Struktursubstrats 8 erreicht werden. Durch Rotation der Trägereinrichtung 9 wird eine Vergleichmäßigung der Abscheidung erreicht. Ebenso kann eventuell überschüssige Flüssigkeit abgeschleudert werden.

### Vorrichtung und Verfahren zum Beschichten eines mikro- und/oder nanostrukturierten Struktursubstrats

### Bezugszeichenliste

- 1: Vorrichtung
- 2: Vernebelungskammer
- 3: Vakuumkammer
- 4: Zwischenkammer
- 5: Verbindungsleitungen
- 6: Absperrventile
- 7: Klappe
- 8: Struktursubstrat
- 9: Trägereinrichtung
- 10: Vakuumrillen
- 11: Heiz-Kühlelement
- 12: Motor
- 13: Vakuumleitung
- 14: (Vernebelungs-)düse
- 15: Heizelemente
- 16: Stufe
- 17: Faltenbalg
- 18: Bodenplatte
- 19: Stellelement
- 20: Sprühdüse
- 21: flexible Verbindungsleitung
- 22: Anschluss
- 23: flexible Ablassleitung

## Patentansprüche

1. Verfahren zum Beschichten eines mikro- und/oder nanostrukturierten Struktursubstrats (8) mit Vertiefungen mit folgenden Verfahrensschritten:
• Beschicken einer Vakuumkammer (3) mit dem Struktursubstrat (8);
• Evakuieren der Vakuumkammer (3);
• Einbringen einer Beschichtungssubstanz
a) in die zumindest teilweise evakuierte Vakuumkammer (3) und auf das Struktursubstrat (8) und Erhöhen des Drucks in der Vakuumkammer (3) mit der Atmosphäre während und/oder nach dem Einbringen der Beschichtungssubstanz, derart, dass die Beschichtungssubstanz in die Vertiefungen hineinbefördert wird oder
b) in eine mit der Vakuumkammer (3) verbundene Vernebelungskammer (2) und Erhöhen des Drucks in der Vakuumkammer (3) durch Öffnen mindestens eines Absperrventils (6) in mindestens einer Verbindungsleitung (5) zwischen Vernebelungskammer (2) und Vakuumkammer (3) derart, dass die Beschichtungssubstanz in die Vertiefungen hineinbefördert wird.

2. Verfahren nach Anspruch 1,
**dadurch gekennzeichnet,**
**dass** die Beschichtungssubstanz flüssig in die Vakuumkammer (3) geleitet wird und/oder in der Vakuumkammer (3) vernebelt wird.

3. Verfahren nach Anspruch einem der Ansprüche 1 oder 1,
**dadurch gekennzeichnet,**
**dass** das Struktursubstrat (8) in der Vakuumkammer (3), vorzugsweise über eine vorgegebene Zeitspanne, erwärmt wird.

4. Verfahren nach einem der Ansprüche 1 bis 3,
**dadurch gekennzeichnet,**
**dass** das Struktursubstrat (8), vorzugsweise vor dem Einbringen der Beschichtungssubstanz, insbesondere nach Erwärmen des Struktursubstrats (8), gekühlt wird.

5. Verfahren nach einem der Ansprüche 1 bis 4,
**dadurch gekennzeichnet,**
**dass** die Beschichtungssubstanz in der Vernebelungskammer (2) vernebelt wird, und dass das Einbringen der Beschichtungssubstanz in die Vakuumkammer (3) nach Erreichen einer gewünschten Beschichtungssubstanzkonzentration in der Vernebelungskammer (2) erfolgt.

6. Verfahren nach Anspruch 5,
dass das Druckniveau in der Vernebelungskammer (2) vor dem Öffnen des Absperrventils (6) höher ist als das Druckniveau der evakuierten Vakuumkammer (3), vorzugsweise dass das Druckniveau in der Vernebelungskammer (2) dem Atmosphärendruck entspricht.

7. Verfahren nach einem der Ansprüche 5 oder 6,
**dadurch gekennzeichnet,**
**dass** die Vernebelungskammer (2) vor und/oder während der Vernebelung der Beschichtungssubstanz erwärmt wird.

8. Verfahren nach einem der Ansprüche 1 bis 7,
**dadurch gekennzeichnet,**
**dass** als Struktursubstrat (8) ein Halbleitersubstrat oder ein geprägtes oder geformtes Kunststoffmaterial oder ein Glassubstrat, vorzugsweise ein Wafer, mit Vertiefungen, vorzugsweise Gräben oder Löchern, mit einer Tiefe von etwa 10nm bis etwa 400µm verwendet wird.

9. Verfahren nach Anspruch 8,
**dadurch gekennzeichnet,**
**dass** die Breite oder der Durchmesser der Vertiefungen kleiner ist als deren Tiefe.

10. Verfahren nach einem der Ansprüche 1 bis 9,
**dadurch gekennzeichnet,**
**dass** als Beschichtungssubstanz Fotolack und/oder Oberflächenaktivierungsmittel und/oder Lösungsmittel und/oder Haftverbesserer verwendet werden.

11. Verfahren nach einem der Ansprüche 1 bis 10,
**dadurch gekennzeichnet,**
**dass** die Verfahrensschritte nach dem Beschicken der Vakuumkammer (3) mit dem Struktursubstrat (8) mehrfach, vorzugsweise mit unterschiedlichen Beschichtungssubstanzen, wiederholt werden.

## Claims

1. A method for coating a micro-structured and/or nano-structured structural substrate (8) with recesses, wherein said method comprises the following steps:
• loading the structural substrate (8) into a vacuum chamber (3);
• evacuating the vacuum chamber (3);
• feeding a coating substance
a) into the at least partially evacuated vacuum chamber (3) and onto the structural substrate (8) and increasing the pressure in the vacuum chamber (3) with the atmosphere during and/or after the infeed of the coating substance such that the coating substance is transported into the recesses or
b) into an atomizing chamber (2) that is connected to the vacuum chamber (3) and increasing the pressure in the vacuum chamber (3) by opening at least one shut-off valve (6) in at least one connecting line (5) between the atomizing chamber (2) and the vacuum chamber (3) such that the coating substance is transported into the recesses.

2. The method according to claim 1,
**characterized in**
**that** the coating substance is delivered into the vacuum chamber (3) in liquid form and/or atomized in the vacuum chamber (3).

3. The method according to one of claims 1 or 2, **characterized in**
**that** the structural substrate (8) is heated in the vacuum chamber (3), preferably over a predefined duration.

4. The method according to one of claims 1 to 3, **characterized in**
**that** the structural substrate (8) is cooled, preferably before the infeed of the coating substance, particularly after the structural substrate (8) has been heated.

5. The method according to one of claims 1 to 4, **characterized in**
**that** the coating substance is atomized in the atomizing chamber (2), and in that the infeed of the coating substance into the vacuum chamber (3) takes place after a desired coating substance concentration has been reached in the atomizing chamber (2).

6. The method according to claim 5,
**characterized in**
**that** the pressure level in the atomizing chamber (2) is higher than the pressure level of the evacuated vacuum chamber (3) before the shut-off valve (6) is opened, wherein the pressure level in the atomizing chamber (2) preferably corresponds to the atmospheric pressure.

7. The method according to one of claims 5 or 6, **characterized in**
**that** the atomizing chamber (2) is heated before and/or during the atomization of the coating substance.

8. The method according to one of claims 1 to 7, **characterized in**
**that** a semiconductor substrate or an embossed or shaped plastic material or a glass substrate, preferably a wafer, with recesses, preferably pits or holes with a depth of about 10 nm to about 400 µm, is used as structural substrate (8).

9. The method according to claim 8,
**characterized in**
**that** the width or the diameter of the recesses is smaller than their depth.

10. The method according to one of claims 1 to 9, **characterized in**
**that** photoresists and/or surface activating agents and/or solvents and/or adhesion promoters are used as coating substances.

11. The method according to one of claims 1 to 10, **characterized in**
**that** the steps after loading the structural substrate (8) into the vacuum chamber (3) are repeated several times, preferably with different coating substances.

## Revendications

1. Procédé de revêtement d'un substrat structurel micro- et/ou nanostructuré (8) doté de creux par les étapes opératoires suivantes :
• revêtement d'une chambre de dépressurisation (3) avec le substrat structurel (8) ;
• mise sous vide de la chambre de dépressurisation (3) ;
• introduction d'une substance de revêtement
a) dans la chambre de dépressurisation (3) au moins partiellement sous vide et sur le substrat structurel (8) et augmentation de la pression dans la chambre de dépressurisation (3) avec l'atmosphère pendant et/ou après l'introduction de la substance de revêtement de manière à ce que la substance de revêtement rentre dans les creux ou
b) dans une chambre de nébulisation (2) raccordée à la chambre de dépressurisation (3) et augmentation de la pression dans la chambre de dépressurisation (3) en ouvrant au moins une soupape d'arrêt (6) dans au moins une conduite de raccordement (5) entre la chambre de nébulisation (2) et la chambre de dépressurisation (3) de manière à ce que la substance de revêtement rentre dans les creux.

2. Procédé selon la revendication 1,
**caractérisé en ce**
**que** la substance de revêtement est guidée sous forme liquide dans la chambre de dépressurisation (3) et/ou nébulisée dans la chambre de dépressurisation (3).

3. Procédé selon l'une des revendications 1 ou 2, **caractérisé en ce**
**que** le substrat structurel (8) est réchauffé dans la chambre de dépressurisation (3), de préférence pendant un laps de temps prédéfini.

4. Procédé selon l'une des revendications 1 à 3, **caractérisé en ce**
**que** le substrat structurel (8) est refroidi de préférence avant l'introduction de la substance de revêtement, en particulier après le réchauffement du substrat structurel (8).

5. Procédé selon l'une des revendications 1 à 4, **caractérisé en ce**
**que** la substance de revêtement est nébulisée dans la chambre de nébulisation (2) et que l'introduction de la substance de revêtement dans la chambre de dépressurisation (3) a lieu une fois qu'une concentration souhaitée de substance de revêtement est atteinte dans la chambre de nébulisation (2).

6. Procédé selon la revendication 5,
**caractérisé en ce**
**que** le niveau de pression dans la chambre de nébulisation (2) est, avant l'ouverture de la soupape d'arrêt (6), supérieur au niveau de pression de la chambre de dépressurisation (3) sous vide, de préférence que le niveau de pression dans la chambre de nébulisation (2) équivaut à la pression atmosphérique.

7. Procédé selon l'une des revendications 5 ou 6, **caractérisé en ce**
**que** la chambre de nébulisation (2) est réchauffée avant et/ou pendant la nébulisation de la substance de revêtement.

8. Procédé selon l'une des revendications 1 à 7, **caractérisé en ce**
**qu'**on utilise comme substrat structurel (8) un substrat semi-conducteur ou une matière plastique gaufrée ou moulée ou un substrat de verre, de préférence une plaquette, comportant des creux, de préférence des gorges ou des trous, ayant une profondeur d'environ 10 nm à environ 400 µm.

9. Procédé selon la revendication 8,
**caractérisé en ce**
**que** la largeur ou le diamètre des creux est inférieur à leur profondeur.

10. Procédé selon l'une des revendications 1 à 9,
**caractérisé en ce**
**qu'**on utilise comme substance de revêtement du vernis photosensible et/ou un agent activateur de surface et/ou du solvant et/ou du promoteur d'adhérence.

11. Procédé selon l'une des revendications 1 à 10, **caractérisé en ce**
**que** les étapes opératoires suivant le revêtement de la chambre de dépressurisation (3) avec le substrat structurel (8) sont répétées plusieurs fois, de préférence avec des substances de revêtement différentes.
